Europäisches Patentamt

European Patent Office

Office européen des brevets

(19)

(11) Publication number: **0 032 025**
**B1**

(12) **EUROPEAN PATENT SPECIFICATION**

(45) Date of publication of patent specification: **13.06.84**

(21) Application number: **80304587.1**

(22) Date of filing: **18.12.80**

(51) Int. Cl.³: **H 01 L 21/31,**
**H 01 L 27/10, H 01 L 23/52**
**//G11C11/40**

(54) A semiconductor device and a method of manufacturing a semiconductor device.

(30) Priority: **30.12.79 JP 173201/79**

(43) Date of publication of application:
**15.07.81 Bulletin 81/28**

(45) Publication of the grant of the patent:
**13.06.84 Bulletin 84/24**

(84) Designated Contracting States:
**DE FR GB NL**

(56) References cited:
**EP - A - 0 002 364**
**GB - A - 2 017 402**
**JP - A - 53 148 398**
**US - A - 4 110 776**
**US - A - 4 125 854**
**US - A - 4 139 785**
**US - A - 4 139 786**
**US - A - 4 143 178**
**US - A - 4 180 826**

**INTERNATIONAL ELECTRON DEVICES**
**MEETING, Technical Digest, 4th-6th December**
**1978, pages 360-363 Washington, U.S.A. T.**
**OHZONE et al.: "A 2Kx8-bit static RAM"**

(73) Proprietor: **FUJITSU LIMITED**
**1015, Kamikodanaka Nakahara-ku**
**Kawasaki-shi Kanagawa 211 (JP)**

(72) Inventor: **Shirai, Kazunari**
**1310-4, Kurinosawa Bukko-cho Hodogaya-ku**
**Yokohama-shi Kanagawa 240 (JP)**

(74) Representative: **Sunderland, James Harry et al,**
**HASELTINE LAKE & CO Hazlitt House 28**
**Southampton Buildings Chancery Lane**
**London WC2A 1AT (GB)**

Courier Press, Leamington Spa, England.

## Description

This present invention relates to a semiconductor device and a method of manufacturing a semiconductor device.

For example, static random access memory devices having 6-element memory cells can be divided into two groups. One group utilizes one or more depletion transistors as one or more resistor elements, and the other group utilizes one or more resistor elements produced as one or more high resistance polycrystal semiconductor layer parts. Albeit that devices of the former group are easier to produce, they are subject to a disadvantage in that a lesser magnitude of integration can be achieved. Therefore, there has been a tendency for devices of the latter group to be more frequently employed.

Static random access memory devices which have one or more resistor elements produced as one or more high resistance polycrystal semiconductor layer parts can be further divided into two categories. One category of device has a single layer level and the other category has a plurality of layer levels. Devices of the latter category are of course advantageous from the point of view of integration density.

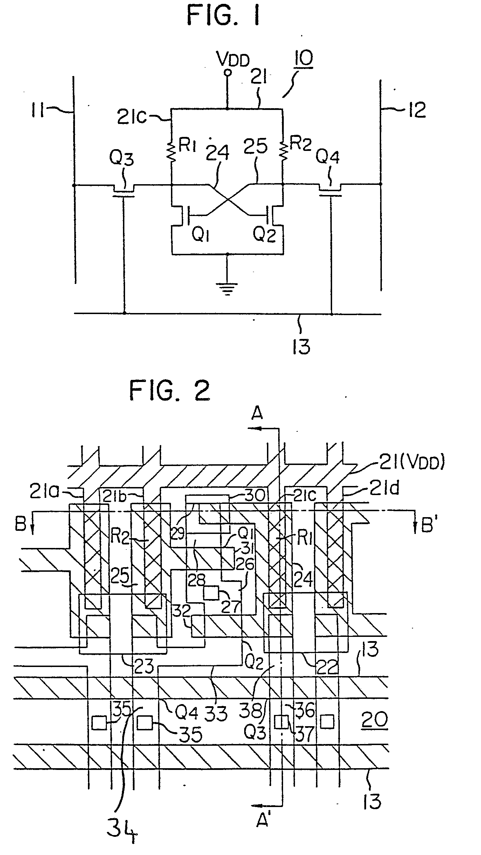

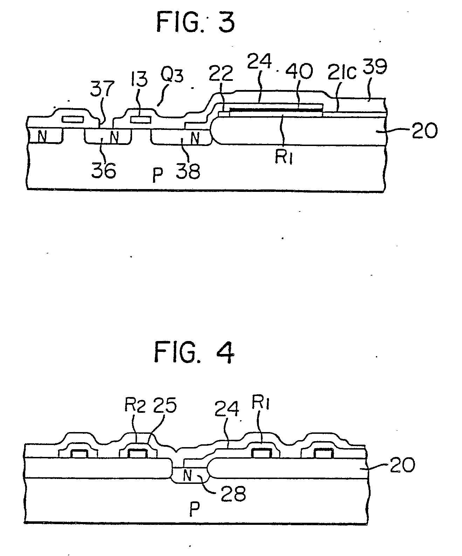

Against this background of production of resistor elements using high resistance polycrystal semiconductor layer parts, for example for memory devices, the inventor has made a proposal which provides for power supply ($V_{DD}$) lines and resistor elements to be produced of a first or lower polycrystal semiconductor layer, and for wirings for various purposes including that of connection of transistors, to be produced in a second or upper polycrystal semiconductor layer. This proposal is described in European Patent Application No. 78300699.2, publication No. 0 002 364, and for the assistance of the reader this proposal will be summarised below in the context of a static type random access memory, with reference to Figures 1 to 4 of the accompanying drawings which are respectively a wiring diagram of a static random access memory cell, a schematic plan view of principal parts of a static random access memory device, a cross-sectional view taken along line A—A' in the schematic plan view, and a cross-sectional view taken along line B—B' in the schematic plan view.

In Figures 1 to 4, $Q_1$, $Q_2$, $Q_3$ and $Q_4$ are transistors, $R_1$ and $R_2$ are load resistors and $V_{DD}$ is a power supply line. 10 indicates a memory cell as a whole. 11 and 12 are bit lines and 13 is a word line. 20 is a field oxide layer and 21 is a portion of a first or lower polycrystal semiconductor layer which constitutes a power supply line $V_{DD}$. 21a, 21b, 21c and 21d are various independent portions of the first or lower polycrystal semiconductor layer which respectively constitute different wirings. 22 and 23 are windows or openings. 24 and 25 are portions of a second polycrystal semiconductor layer which constitute independent wirings. 26 is a source region provided in common for transistors $Q_1$ and $Q_2$, 27 is a window or an opening for contacting an electrode, 28 is a drain region and 29 is an edge of the drain region. 30 is a window or an opening, 31 is a silicon gate of transistor $Q_1$, 32 is a silicon gate of transistor $Q_2$, 33 is a drain region provided in common for transistors $Q_2$ and $Q_4$, 34 is a source region of transistor $Q_4$, 35 are contact windows, 36 is a source region of transistor $Q_3$, 37 is a contact window, 38 is a drain region of transistor $Q_3$, 39 is a phospho-silicate glass film and 40 is an oxide film.

In the above described arrangement, a plurality of polycrystal semiconductor layer levels are employed. In this sense, magnitude of integration can be improved to a considerable extent. It is noted, however, that the configuration employing a plurality of layer levels is not applied to high resistance polycrystal conductive layer parts. In other words, a plural layer level configuration is not used in a memory cell region or active element per se and the application of the plural layer configuration for polycrystal semiconductor layers is limited to a field region. The high resistance polycrystal parts have to be specially established and polycrystal layer parts are on different levels only over field oxide film parts, not over active element parts.

United States Patent Specification No. 4,143,178 discloses a method of manufacturing a semiconductor device in which a first polycrystalline semiconductor layer which is doped with impurity and which extends over a gate insulator layer on a substrate, has a second polycrystalline semiconductor layer, without doped impurity, formed thereon. In a thermal oxidising step the second polycrystalline semiconductor layer is doped with impurity diffused from the first polycrystalline semiconductor layer.

United States Patent Specification No. 4,234,889 discloses a semiconductor device having a p-type substrate and two polycrystalline silicon layer levels. The substrate is provided with $N^+$ moat regions. Areas of a first polycrystalline layer level, which layer level extends over a gate insulator layer on the substrate are highly conductive. The whole of a second polycrystalline layer level is subjected to phosphorus implantation to create the characteristics of resistors. Areas of the second level are later subject to phosphorus deposition and diffusion to render them highly conductive. One area of the second level which is subject to such deposition and diffusion contacts a moat region.

According to the present invention there is provided a semiconductor device, having a semiconductor substrate provided with a relatively heavily doped region, a thin gate insulator layer on the substrate, and first level and second level polycrystal semiconductor layers, the first level polycrystal semiconductor layer extending over the gate insulator layer, the first level polycrystal semiconductor layer being relatively heavily doped and the second level polycrystal semiconductor layer having a part which is relatively heavily doped, the relatively heavily doped part of the second level polycrystal semiconductor layer contacting the relatively heavily doped region with which the substrate is provided, characterised in that the second level polycrystal semiconductor layer contacts the first level polycrystal semiconductor layer at a portion over the thin gate insulator layer and extends therefrom over the relatively heavily doped region of the substrate, located contiguously with the said portion, thereby to interconnect the first level polycrystal semiconductor layer with the relatively heavily doped region, and characterised in that the relatively heavily doped part of the second level polycrystal semiconductor layer is doped as a result of upward diffusion of impurities from the relatively heavily doped region with which the substrate is provided.

According to the present invention there is also provided a method of manufacturing a semiconductor device, comprising providing a substrate with a relatively heavily doped region, growing a thin gate insulator layer on the substrate, and growing first level and second level polycrystal semiconductor layers, the first level polycrystal semiconductor layer extending over the gate insulator layer and being relatively heavily doped, and the second level polycrystal semiconductor layer being provided with a part which is relatively heavily doped, in contact with said relatively heavily doped region with which the substrate is provided,

the second level polycrystal semiconductor layer being formed so as to contact the first level polycrystal semiconductor layer at a portion over the thin gate insulator layer and to extend therefrom over the relatively heavily doped region of the substrate, located contiguously with the said portion, thereby to interconnect the first level polycrystal semiconductor layer with the relatively heavily doped region,

and the part of the second level polycrystal layer which is relatively heavily doped being doped by upward diffusion of impurities from the relatively heavily doped region with which the substrate is provided.

An embodiment of the present invention can provide a highly integrated semiconductor device realized by employment of a plural polycrystal conductive layer configuration.

An embodiment of this invention can provide a method of production of a highly integrated semiconductor device which is realized by employment of a plural polycrystal conductive layer configuration.

An embodiment of this invention can provide a method for production of a highly integrated semiconductor device without employing a so-called non butting process.

Embodiments of this invention can be applied, for example only, to static random access memory devices.

In embodiments of this invention one or more resistor elements can be provided in a plural polycrystal semiconductor layer configuration.

In an embodiment of this invention, a semiconductor device, which may be highly integrated, is provided with (a) a highly doped first polycrystal semiconductor layer, parts of which are perforated, grown on a first insulator layer, and which is utilized for providing electrodes and/or wirings for elements produced in a substrate in parts of which highly doped regions are located to constitute various elements therein, (b) a second insulator layer, parts of which are perforated, on the first polycrystal semiconductor layer, (c) a patterned second polycrystal semiconductor layer, grown on the second insulator layer, which is relatively less doped than highly doped parts excepting in regions which contact the substrate (and regions which contact the first polycrystal semiconductor layer, if any), which regions are highly doped as a result of upward diffusion of impurities from the highly doped regions of the substrate (and from first polycrystal semiconductor layer).

A method, embodying this invention, for production of a highly integrated semiconductor device which has a plural polycrystal conductive layer configuration, comprises (a) a step for growing a doped or undoped first polycrystal semiconductor layer on a first insulator layer grown on a semiconductor substrate (this first polycrystal semiconductor layer can be doped or undoped at this stage depending on a specific required arrangement of elements and the process steps), (b) a step for patterning the first polycrystal semiconductor layer for production of electrodes and/or wirings for active elements produced in the substrate, (c) a step for selectively introducing impurities into the substrate and, if required, into the first polycrystal semiconductor (an ion implantation process is preferable for this step for accurate doping control, but an ordinary diffusion process can alternatively be used. The first polycrystal semiconductor layer, if doped, may be undoped in this step).

In other words, in this step processes aimed at doping either the substrate or the first polycrystal semiconductor layer or both the substrate and the first polycrystal semiconductor layer are effected. In any event, portions of the substrate not covered by the first polycrystal semiconductor layer must ultimately be doped in this step to form, for example, source and drain regions. A thick oxide film, as well as the first polycrystal semiconductor layer, functions as a mask to define the source and drain regions.

Thus, if the first polycrystal semiconductor layer has previously been doped, this step is merely to introduce impurities into the substrate, and if the first polycrystal semiconductor layer has not been doped, this step is to introduce impurities into both the substrate and the first polycrystal semiconductor layer.

(d) A step for growing a second insulator layer on the first polycrystal semiconductor layer which has been heavily doped in a proceeding step, (e) a step for perforating openings in the second insulator layer to extend to the substrate (and for perforating openings to the first polycrystal semiconductor layer if required) depending on a specific required arrangement of elements, (f) a step for growing a relatively less doped second polycrystal semiconductor layer on the second insulator layer, and (g) a step for causing upward diffusion of impurities through openings from the substrate (and from the first polycrystal semiconductor layer, if appropriate).

Reference is made, by way of example, to the accompanying drawings, in which:—

Figure 1 is a schematic wiring diagram of a previously proposed static random access memory cell;

Figure 2 is a schematic plan view of principal parts of a previously proposed static random access memory device;

Figure 3 is a cross-sectional view taken along line A—A' of Figure 2;

Figure 4 is a cross-sectional view taken along line B—B' of Figure 2;

Figures 5 to 8 are respective cross-sectional views, taken along a line A—A' in Figure 9, of principal portions of a static random access memory device embodying the present invention, respectively illustrating structures provided after twelve, fourteen, nineteen and twenty-three production steps; and

Figure 9 is a schematic plan view of principal parts of a static random access memory device embodying this invention.

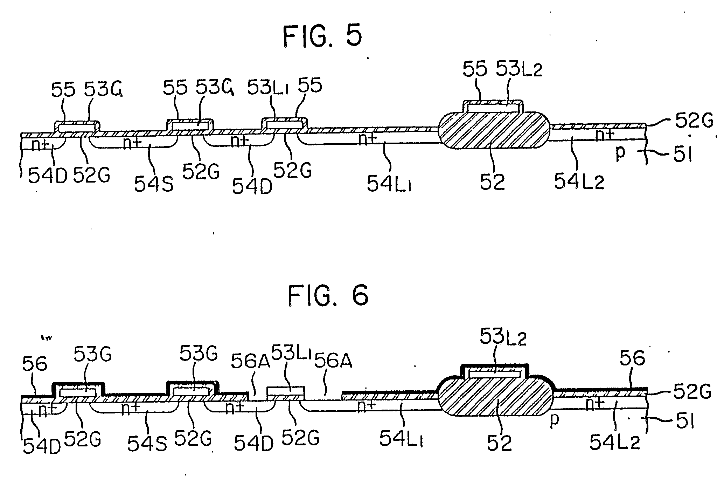

With reference to Figures 5 to 8 and Figure 9, steps for production of, and the arrangement and configuration of, a highly integrated semiconductor device embodying this invention will be described below, for a case in which the semiconductor device is produced on a p-type silicon substrate. Only by way of example is the semiconductor device taken to be a static random access memory device.

Referring to Figure 5, a silicon dioxide film of a thickness of, for example, 500 angstroms is grown on a p-type silicon substrate 51 having a crystal index (100) by means of a thermal oxidation process. The purpose of this process is to produce a sublayer for a silicon nitride mask to be employed as a mask for a selective thermal oxidation process to be carried out later. A second step is to grow, using a chemical vapour deposition process, a silicon nitride film of a thickness of, for example, 1,000 angstroms. A third step is to use a lithography process for patterning the silicon nitride film. A fourth step is to employ an ion implantation process to introduce boron ions into the substrate or water for production of a channel cut region (not shown). The energy level employed for this ion implantation process is approximately 50 KeV. Impurity concentration (dose) is preferably approximately $10^{13}/cm^2$. A fifth step is to employ a thermal oxidation process for growing a field silicon oxide layer 52 to a thickness of, for example, 8,000 angstroms. A sixth step is to remove the silicon nitride film employed as a mask in the fifth step and to remove the silicon dioxide sublayer. As a result, the surface of the substrate 51 is uncovered except for a field silicon dioxide layer 52. A seventh step is to grow anew, by a thermal oxidation process, a gate oxide film 52G of excellent quality and to a thickness of, for example, 500 angstroms. An eighth step is to employ a chemical vapour deposition process for forming a first polycrystal silicon layer to a thickness of for example, 4,000 angstroms. A ninth step is to etch selectively the first polycrystal silicon layer for the production of various elements, such as silicon gates or word lines 53G, wirings $53L_1$ and $53L_2$ et al. A tenth step is to effect a patterning process for the gate oxide film 52G. It will be seen that the first polycrystal silicon layer extends over the gate oxide film. An eleventh step is to employ an ion implantation process to introduce arsenic ions into selected portions of the wafer or substrate where the substrate is not covered either by the field oxide layer 52 or the first polycrystal silicon layer for production of n-doped regions such as source regions 54S, drain regions 54D, wiring regions $54L_1$ and $54L_2$ et al. A twelfth step is to employ a thermal oxidation process to produce an oxide film 55 on the entire surface of the wafer (e.g. over all exposed upper surfaces). This is shown in Figure 5.

Referring to Figure 6, a thirteenth step is to employ a chemical vapour deposition process for growing a silicon nitride layer 56 to a thickness of, for example, 700 angstroms on the entire surface of the wafer (e.g. over all exposed surfaces). A fourteenth step is to employ a lithography process to remove selectively the silicon nitride layer 56 and the oxide layers 55 and 52G for production of contact holes 56A. This is shown in Figure 6.

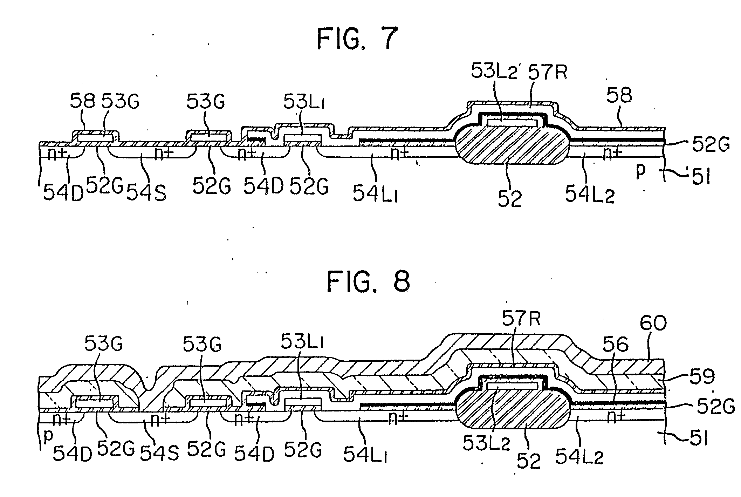

Referring to Figure 7, a fifteenth step is to employ a chemical vapour deposition process for growing a second polycrystal silicon layer to a thickness of, for example, 4,000 angstroms on the entire surface of the wafer (e.g. over all exposed surfaces). Since this polycrystal silicon layer is be utilized mainly for resistor elements, the layer is undoped or lightly doped when grown, to be partly doped later to a required impurity concentration by a specific process described below. This doping process is important. Namely, since upper surface portions of or on the substrate with which the second polycrystal silicon layer comes into direct contact are limited to highly doped regions such as wiring regions $53L_1$ (of the first polycrystal layer), drain regions 54D and wiring regions $54L_1$, the dopant contained in these upper surface portions diffuses upwards into the second polycrystal silicon layer during a heating process carried out later. As a result, the second polycrystal silicon layer is selectively doped in limited locations to allow ohmic contacts to be made between specific portions on or in the substrate and the second polycrystal silicon layer, such as wiring regions $53L_1$, drain regions 54D and wiring region $54L_1$. A sixteeth step is to employ an ion implantation process to introduce phosphorus ions to the whole of the second polycrystal silicon layer without any masking step. The purpose of this process is to adjust the resistivity of the layer to suit it to the resistor elements. The energy level employed is for example 50 KeV, and the preferable impurity concentration (dose) is, for example $10^{13}/cm^2$. Needless to emphasize, this process incidentally supplements the above-described upward diffusion doping process. A seventeenth step is to employ a lithography process for patterning the second polycrystal silicon layer. The purpose of this process is to fabricate resistor elements 57R et al. An eighteenth step is to employ an etching process to remove parts of the silicon nitride film 56 and portions of the silicon oxide films 55 and 52G (where the second polycrystal silicon layer has been removed). This etching process is carried out successively with the above lithography process. A nineteeth step is grow a silicon oxide film 58 having a thickness of, for example, 1,000 angstroms.

This is shown in Figure 7, in which it will be seen that the second polycrystal silicon layer contacts the first polycrystal silicon layer at a portion ($53L_1$) over the gate oxide film (52G) and extends therefrom over a relatively heavily doped region ($54D, 54L_1$) of the substrate, contiguous with the contacted portion of the first polycrystal silicon layer, to interconnect the first polycrystal silicon layer with the relatively heavily doped region.

Referring to Figure 8, a twentieth step is to employ a chemical vapour deposition process for growing a phospho silicate glass film 59 having a thickness of, for example, 1 $\mu$m. A twentyfirst step is to employ a lithography process for patterning the phospho silicate glass film 59. The purpose of this process is to perforate the film 59 to provide contact holes for electrodes. A twentysecond step is employ an evaporation process for providing an aluminium film of a thickness of, for example, 1 $\mu$m. A twentythird step is to employ a lithography process for patterning the aluminium film. The purpose of this process is to fabricate electrodes and/or wirings 60 which constitute bit lines and power supply lines et al.

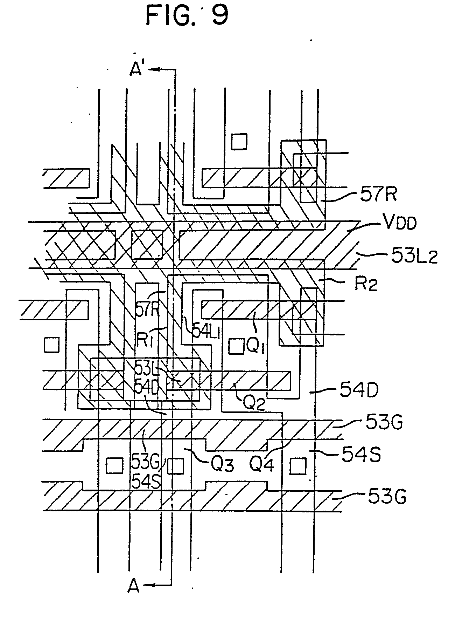

Figure 9 shows a schematic plan view of major portions of a static random access memory device embodying this invention. As described earlier, Figures 5 to 8 are cross-sectional views taken along the line A—A' shown in this Figure.

It will be clear from the above description that in embodiments of this invention, no limitation is imposed on the location of resistor elements fabricated in the second polycrystal semiconductor layer. In other words, resistor elements can be fabricated in the second polycrystal semiconductor layer at arbitrary locations. This is effective for improvement of circuit integration for a semiconductor device. Further, ohmic contact between substrate portions (and a first polycrystal semiconductor layer, if desired) and resistor elements fabricated in the second polycrystal semiconductor layer is realised by upward diffusion of impurities from the substrate and from the first polycrystal semiconductor layer (if appropriate) towards specific required regions of the second polycrystal semiconductor layer. Therefore, impurity concentration can be freely selected for the second polycrystal semiconductor layer. This effectively allows selection of an optimum resistivity for forming a resistor element having a desired resistance. Further, a so-called non butting process is not required.

A wiring configuration having a plurality of polycrystal semiconductor layers can provide for improved magnitude of circuit integration. In embodiments of this invention one, or more, upper polycrystal semiconductor layers, which is or are doped to a moderate impurity concentration or not doped, is or are utilized as resistor elements, and a lowest polycrystal semiconductor layer, which is highly doped, is utilized for electrodes and/or wirings for active elements. The lowest and upper polycrystal layers are connected with each other by regions which are highly doped by upward diffusion of impurities contained in highly doped regions of a substrate (and if appropriate), the lowest polycrystal layer. This arrangement entirely removes restrictions on location of resistor elements arranged in the upper layers. This arrangement is realised in an embodiment of this invention by a specific sequence of steps which includes a step for upward diffusion of impurities from highly doped regions of a substrate (and the lowest polycrystal semiconductor layer, if appropriate). An additional advantage of an embodiment of this invention is that a so-called non butting process is not required.

**Claims**

1. A semiconductor device, having a semiconductor substrate provided with a relatively heavily doped region ($54D, 54L_1$), a thin gate insulator layer (52G) on the substrate, and first level ($53L_1$) and second level (57R) polycrystal semiconductor layers, the first level polycrystal semiconductor layer extending over the gate insulator layer, the first level polycrystal semiconductor layer being relatively heavily doped and the second level polycrystal semiconductor layer having a part which is relatively heavily doped, the relatively heavily doped part of the second level polycrystal semiconductor layer contacting the relatively heavily doped region with which the substrate is provided, characterised in that the second level polycrystal semiconductor layer contacts the first level polycrystal semiconductor layer at a portion over the thin gate insulator layer and extends therefrom over the relatively heavily doped region of the substrate, located contiguously with the said portion, thereby to interconnect the first level polycrystal semiconductor layer with the relatively heavily doped region, and characterised in that the relatively heavily doped part of the second level polycrystal semiconductor layer is doped as a result of upward diffusion of impurities from the relatively heavily doped region with which the substrate is provided.

2. A device as claimed in claim 1, having also a thick field insulator layer (52) on the substrate, the first level polycrystal semiconductor layer extending over the field insulator layer.

3. A device as claimed in claim 1 or 2, wherein the second level polycrystal semiconductor layer is in general relatively lightly doped or not doped.

4. A device as claimed in claim 1, 2 or 3, wherein the part of the second level polycrystal semiconductor layer which contacts the portion of the first level polycrystal semiconductor layer is doped as a result of upward diffusion of impurities from the first level polycrystal semiconductor layer.

5. A semiconductor device as claimed in any preceding claim, wherein the first level polycrystal semiconductor layer is employed for providing wiring and electrodes and the second level polycrystal semiconductor layer is employed for providing resistors.

6. A semiconductor device as claimed in claim 2, or any one of claims 3 to 5 read as appended to claim 2, wherein the first level polycrystal semiconductor layer is formed on a first insulator layer which is formed on the substrate of the device, parts of which first insulator layer are perforated and which first insulator layer provides the thin gate insulator layer and the thick field insulator layer, a second insulator layer is formed on the first polycrystal semiconductor layer, parts of the second insulator layer being perforated, and the second polycrystal semiconductor layer is formed and patterned on the second insulator layer.

7. A method of manufacturing a semiconductor device, comprising providing a substrate with a relatively heavily doped region (54D, 54L₁), growing a thin gate insulator layer (52G) on the substrate, and growing first level (53L₁) and second level (57R) polycrystal semiconductor layers, the first level polycrystal semiconductor layer extending over the gate insulator layer and being relatively heavily doped, and the second level polycrystal semiconductor layer being provided with a part which is relatively heavily doped, in contact with said relatively heavily doped region with which the substrate is provided,

the second level polycrystal semiconductor layer being formed so as to contact the first level polycrystal semiconductor layer at a portion over the thin gate insulator layer and to extend therefrom over the relatively heavily doped region of the substrate, located contiguously with the said portion, thereby to interconnect the first level polycrystal semiconductor layer with the relatively heavily doped region,

and the part of the second level polycrystal layer which is relatively heavily doped being doped by upward diffusion of impurities from the relatively heavily doped region with which the substrate is provided.

8. A method as claimed in claim 7, comprising growing also a thick field insulator layer (52) on the substrate, and growing the first level polycrystal semiconductor layer so as to extend also over the field insulator layer.

9. A method as claimed in claim 7 or 8, wherein the second level polycrystal semiconductor layer is in general relatively lightly doped or not doped.

10. A method as claimed in claim 7, 8 or 9, wherein a first insulator layer is grown, on the substrate of the device, which first insulator layer provides the gate insulator layer and the field insulator layer, the first level polycrystal semiconductor layer is grown, on the first insulator layer, and is patterned, impurities are introduced into exposed parts of the substrate, a second insulator layer is grown, on the first level polycrystal semiconductor layer, after doping of the first level polycrystal semiconductor layer, and the second insulator layer is provided with perforations, in which conductive parts of the substrate and first level polycrystal semiconductor layer are exposed, the second level polycrystal semiconductor layer is grown on the second insulator layer, the second level polycrystal semiconductor layer being relatively lightly doped, and conditions are established for upward diffusion of impurities into the second level polycrystal semiconductor layer from the parts exposed in the perforations in the second insulator layer with which the second level polycrystal semiconductor layer is in contact.

11. A method as claimed in any one of claims 7 to 10, wherein the first level polycrystal semiconductor layer is patterned for providing electrodes and wiring for active elements produced in the substrate, and the second level polycrystal semiconductor layer is so doped as to provide resistors of selected resistance values.

12. A semiconductor device as claimed in any one of claims 1 to 6, or a semiconductor device manufactured by a method as claimed in any one of claims 7 to 11, being a static random access memory device.

**Patentansprüche**

1. Halbleitervorrichtung, mit einem Halbleitersubstrat mit einem relativ stark dotierten Bereich (54D, 54L1), mit einer dünnen Gateisolierschicht (52A) auf dem Substrat,

mit einer polykristallinen Halbleiterschicht (53L1) in einer ersten Höhe und mit einer polykristallinen Halbleiterschicht (57R) in einer zweiten Höhe, wobei die polykristalline Halbleiterschicht in der ersten Höhe sich über die Gateisolierschicht erstreckt und die polykristalline Halbleiterschicht in der ersten Höhe relativ stark dotiert ist, während die polykristalline Halbleiterschicht in der zweiten Höhe einen Abschnitt hat, welcher relativ stark dotiert ist und dieser relativ stark dotierte Abschnitt der polykristallinen Halbleiterschicht in der zweiten Höhe den relativ stark dotierten Bereich des Substrats berührt, dadurch gekennzeichnet, daß die polykristalline Halbleiterschicht in der zweiten Höhe die polykristalline Halbleiterschicht in der ersten Höhe an einem Abschnitt über der dünnen Gateisolierschicht berührt und sich von dieser über den relativ stark dotierten Bereich des Substrats erstreckt, welcher an den genannten Abschnitt angrenzend angeordnet ist, wodurch die polykristalline Halbleiterschicht in der ersten Höhe mit dem relativ stark dotierten Bereich verbunden wird, und dadurch gekennzeichnet, daß der relativ stark dotierte Abschnitt der polykristallinen Halbleiterschicht in der zweiten Höhe als Folge einer Aufwärtsdiffusion von Verunreinigungen von dem relativ stark dotierten Bereich des Substrates dotiert ist.

2. Halbleitervorrichtung nach Anspruch 1, mit einer dicken Feldisolierschicht (52) auf dem Substrat, wobei die polykristalline Halbleiterschicht in der ersten Höhe sich über die Feldisolierschicht erstreckt.

3. Halbleitervorrichtung nach Anspruch 1 oder 2, bei welcher die polykristalline Halbleiterschicht in der zweiten Höhe im allgemeinen relativ schwach dotiert oder nicht dotiert ist.

4. Halbleitervorrichtung nach Anspruch 1, 2 oder 3, in welcher der Abschnitt der polykristallinen Halbleiterschicht in der zweiten Hone, welche den Abschnitt der polykristallinen Halbleiterschicht in der ersten Höhe berührt, infolge einer Aufwärtsdiffusion von Verunreinigungen von der polykristallinen Halbleiterschicht in der ersten Höhe dotiert ist.

5. Halbleitervorrichtung nach einem der vorhergehenden Ansprüche, bei welcher die polykristalline Halbleiterschicht in der ersten Höhe dazu verwendet wird, Verdrahtung und Elektroden zu liefern, und die polykristalline Halbleiterschicht in der zweiten Höhe zur Bildung von Widerständen verwendet wird.

6. Halbleitervorrichtung nach Anspruch 2 oder nach einem der Ansprüche 3 bis 5 in Verbindung mit Anspruch 2, bei welcher die polykristalline Halbleiterschicht in der ersten Höhe auf einer ersten Isolierschicht gebildet ist, welche auf dem Substrat der Vorrichtung geformt ist, wobei Teile der ersten Isolierschicht perforiert sind und die erste Isolierschicht die dünne Gateisolierschicht und die dicke Feldisolierschicht bildet, und eine zweite Isolierschicht auf der ersten polykristallinen Halbleiterschicht gebildet ist, wobei Abschnitte der zweiten Isolierschicht perforiert sind, und die zweite polykristalline Halbleiterschicht auf der zweiten Isolierschicht geformt und gemustert ist.

7. Verfahren zur Herstellung einer Halbleitervorrichtung, bei welcher

ein Substrat mit einem relativ stark dotierten Bereich (54D, 54L1) gebildet wird,

eine dünne Gateisolierschicht (52A) auf dem Substrat aufgewachsen wird und polykristalline Halbleiterschichten in einer ersten Höhe (53L1) und in einer zweiten Höhe (57R) aufgewachsen werden,

wobei die polykristalline Halbleiterschicht in der ersten Höhe sich über der Gateisolierschicht erstreckt und relativ stark dotiert ist, und die polykristalline Halbleiterschicht in der zweiten Höhe, welche einen relativ stark dotierten Abschnitt aufweist, mit dem genannten relativ stark dotierten Bereich des Substrates in Berührung steht,

die polykristalline Halbleiterschicht der zweiten Höhe so geformt wird, daß sie mit der polykristallinen Halbleiterschicht der ersten Höhe bei einem Abschnitt über der dünnen Gateisolierschicht in Berührung steht und sich von dieser über den relativ stark dotierten Bereich des Substrates erstreckt, welcher an den genannte Abschnitt angrenzend angeordnet ist, wodurch die polykristalline Halbleiterschicht in der ersten Höhe mit dem relativ stark dotierten Bereich verbunden wird,

und der Abschnitt der polykristallinen Schicht in der zweiten Höhe, welcher relativ stark dotiert ist, durch Aufwärtsdiffusion von Verunreinigungen von dem relativ stark dotierten Bereich des Substrates dotiert wird.

8. Verfahren nach Anspruch 7, bei welchem auch eine dicke Feldisolierschicht (52) auf dem Substrat aufgewachsen wird und die polykristalline Halbleiterschicht in der ersten Höhe so aufgewachsen wird, daß sie sich auch über die Feldisolierschicht erstreckt.

9. Verfahren nach Anspruch 7 oder 8, bei welchem die polykristalline Halbleiterschicht in der zweiten Höhe im allgemeinen relativ leicht dotiert oder nicht dotiert ist.

10. Verfahren nach Anspruch 7, 8 oder 9, bei welchem auf dem Substrat der Vorrichtung eine erste Isolierschicht aufgewachsen wird, welche die Gateisolierschicht und die Feldisolierschicht bildet,

eine polykristalline Halbleiterschicht in einer ersten Höhe auf der ersten Isolierschicht aufgewachsen und gemustert wird,

Verunreinigungen in die exponierten Abschnitte des Substrates eingeführt werden,

eine zweite Isolierschicht auf der polykristallinen Halbleiterschicht in der ersten Höhe nach dem Dotieren der polykristallinen Halbleiterschicht in der ersten Höhe aufgewachsen wird, und die zweite Isolierschicht mit Perforationen versehen wird, in welchen leitende Abschnitte des Substrats und der polykristallinen Halbleiterschicht in der ersten Höhe exponiert sind, die polykristalline Halbleiterschicht der zweiten Höhe auf der zweiten Isolierschicht aufgewachsen wird, wobei die polykristalline Halbleiterschicht der zweiten Höhe relativ leicht dotiert ist, und Zustände für die Aufwärtsdiffusion von Verunreinigungen in die polykristalline Halbleiterschicht in der zweiten Höhe von den in den Perforationen exponierten Abschnitten in der zweiten Halbleiterschicht hergestellt werden, mit welcher die polykristalline Halbleiterschicht in der zweiten Höhe in Kontakt ist.

11. Verfahren nach einem der Ansprüche 7 bis 10, bei welchem die polykristalline Halbleiterschicht in der ersten Höhe gemustert wird, um Elektroden und Verdrahtung für in dem Substrat erzeugte aktive Elemente zu bilden, und die polykristalline Halbleiterschicht in der zweiten Höhe so dotiert wird, um Widerstände mit ausgewählten Widerstandswerten zu bilden.

12. Halbleitervorrichtung nach einem der Ansprüche 1 bis 6, oder Halbleitervorrichtung, hergestellt nach einem Verfahren wie es in einem der Ansprüche 7 bis 11 beansprucht ist, welche eine statische Speichervorrichtung mit wahlfreiem Zugriff ist.

**Revendications**

1. Dispositif semiconducteur, possédant un substrat semiconducteur doté d'une région assez fortement dopée (54D, 54L₁), une mince couche isolante de grille (52G) placée sur le substrat, et des couches semiconductrices polycristallines d'un premier niveau (53L₁) et d'un deuxième niveau (57R), la couche semiconductrice polycristalline du premier niveau s'étendant au-dessus de la couche isolante de grille, la couche semiconductrice polycristalline du premier niveau étant assez fortement dopée et la couche semiconductrice polycristalline du deuxième niveau ayant une partie qui est assez fortement dopée, la partie assez fortement dopée de la couche semiconductrice polycristalline du deuxième niveau étant en contact avec la région assez fortement dopée dont le substrat est doté, caractérisé en ce que la couche semiconductrice polycristalline du deuxième niveau est en contact avec la couche semiconductrice polycristalline du premier niveau en une partie située au-dessus de la mince couche isolante de grille et s'étend, depuis celle-ci, au-dessus de la région assez fortement dopée du substrat, située en contiguïté avec ladite partie, de façon à ainsi interconnecter la couche semiconductrice polycristalline du premier niveau avec la région assez fortement dopée, et caractérisé en ce que la partie assez fortement dopée de la couche semiconductrice polycristalline du deuxième niveau subit un dopage par suite d'une diffusion remontante d'impuretés venant de la région assez fortement dopée dont le substrat est doté.

2. Dispositif selon la revendication 1, possédant également une épaisse couche isolante de champ (52) placée sur le substrat, la couche semiconductrice polycristalline du premier niveau s'étendant au-dessus de la couche isolante de grille.

3. Dispositif selon la revendication 1 ou 2, où la couche semiconductrice polycristalline du deuxième niveau est en général assez légèrement dopée ou non dopée.

4. Dispositif selon la revendication 1, 2 ou 3, où la partie de la couche semiconductrice polycristalline du deuxième niveau qui est en contact avec la partie de la couche semiconductrice polycristalline du premier niveau subit un dopage par suite d'une diffusion remontante · d'impuretés venant de la couche semiconductrice polycristalline du premier niveau.

5. Dispositif semiconducteur selon l'une quelconque des revendications précédentes, où la couche semiconductrice polycristalline du premier niveau est utilisée pour former un câblage et des électrodes, et la couche semiconductrice polycristalline du deuxième niveau est utilisée pour former des résistances.

6. Dispositif semiconducteur selon la revendication 2 ou l'une quelconque des revendications 3 à 5 dépendant de la revendication 2, où la couche semiconductrice polycristalline du premier niveau est formée sur une première couche isolante qui est formée sur le substrat du dispositif, des parties de la première couche isolante étant perforées et la première couche isolante formant la mince couche isolante de grille et la couche épaisse isolante de champ, une deuxième couche isolante est formée sur la première couche semiconductrice polycristalline, des parties de la deuxième couche isolante étant perforées, et la deuxième couche semiconductrice polycristalline est formée et tracée sur la deuxième couche isolante.

7. Procédé de fabrication d'un dispositif semiconducteur, consistant à produire un substrat doté d'une région assez fortement dopée (54D, 54L₁), à faire croître une mince couche isolante de grille (52G) sur le substrat, et à faire croître des couches semiconductrices polycristallines d'un premier niveau (53L₁) et d'un deuxième niveau (57R), la couche semiconductrice polycristalline du premier niveau s'étendant sur la couche isolante de grille et étant assez fortement dopée, et la couche semiconductrice polycristalline du deuxième niveau étant dotée d'une partie qui est assez fortement dopée, en contact avec ladite région assez fortement dopée dont le substrat est doté,

la couche semiconductrice polycristalline du deuxième niveau étant formée de façon à être en contact avec la couche semiconductrice polycristalline du premier niveau en une partie située au-dessus de la mince couche isolante de grille et à s'étendre, depuis celle-ci, au-dessus de la région assez fortement dopée du substrat, située en contiguïté avec ladite partie, afin d'interconnecter la couche semiconductrice polycristalline du premier niveau avec la région assez fortement dopée, et

la partie de la couche polycristalline du deuxième niveau qui est assez fortement dopée subissant un dopage par une diffusion remontante d'impuretés venant de la région assez fortement dopée dans le substrat est doté.

8. Procédé selon la revendication 7, comprenant l'opération consistant à faire également croître une couche épaisse isolante de champ (52) sur le substrat, et à faire croître la couche semiconductrice polycristalline du premier niveau de façon qu'elles s'étendent également au-dessus de la couche isolante de champ.

9. Procédé selon la revendication 7 ou 8, où la couche semiconductrice polycristalline du deuxième niveau est un général assez faiblement dopée ou non dopée.

10. Procédé selon la revendication 7, 8 ou 9, où on fait croître une première couche isolante sur le substrat du dispositif, laquelle première couche isolante forme la couche isolante de grille et la couche isolante de champ, on fait croître la couche semiconductrice polycristalline du premier niveau sur la première couche isolante et on y effectue un tracé, on introduit des impuretés dans des parties exposées du substrat, on fait croître un deuxième couche isolante sur la couche semiconductrice polycristalline du premier niveau après dopage de la couche semiconductrice polycristalline du premier niveau, et on dote la deuxième couche isolante de perforations, dans lesquelles des parties conductrices du substrat et de la couche semiconductrices polycristalline du premier niveau sont mises à nu, on fait croître la couche semiconductrice polycristalline du deuxième niveau sur la deuxième couche isolante, la couche semiconductrice polycristalline du deuxième niveau étant assez faiblement dopée, et on établit les conditions d'une diffusion remontante d'impuretés dans la couche semiconductrice polycristalline du deuxième niveau depuis les parties mises à nu se trouvant dans les perforations de la deuxième couche isolante avec laquelle la couche semiconductrice polycristalline du deuxième niveau est un contact.

11. Procédé selon l'une quelconque des revendications 7 à 10, où on effectue un tracé sur la couche semiconductrice polycristalline du premier niveau afin de former des électrodes et un câblage pour des éléments actifs produits dans le substrat, et on dope la couche semiconductrice polycristalline du deuxième niveau afin de former des résistances de valeurs choisies.

12. Dispositif semiconducteur selon l'une quelconque des revendications 1 à 6, ou bien dispositif semiconducteur fabriqué par le procédé selon l'une quelconque des revendications 7 à 11, qui est une mémoire vive statique.

## FIG. 1

## FIG. 2

## FIG. 3

## FIG. 4

## FIG. 5

55 53G    55 53G    53L₁ 55

55 53L2

n⁺    n⁺    n⁺    n⁺    p    n⁺    52G
                                       51

54D 52G    54S 52G    54D 52G    54L₁    52    54L2

## FIG. 6

53L2

56    53G    53G    56A 53L₁ 56A    56

n⁺    n⁺    n⁺    n⁺    p    n⁺    52G
                                       51

54D 52G    54S 52G    54D 52G    54L₁    52    54L2

## FIG. 7

## FIG. 8

# FIG. 9